# EUROPEAN PATENT APPLICATION

(11) **EP 1 713 100 A1**
(43) Date of publication of application: **18.10.2006**
(21) Application number: 06007417.6
(22) Date of filing: 07.04.2006
(51) Int. Cl.: H01G 4/33

(54) **Low loss thin film capacitor structure and method of manufacturing the same**

(30) Priority: 13.04.2005 US 670805 P
(71) Applicant: GENNUM CORPORATION, Burlington, Ontario L7L 5P5 (CA)
(72) Inventor: Cervin-Lawry, Andrew, Ontario L6M 2C6 (CA); Capanu, Mircea, St. Catharines Ontario L6M 2C6 (CA); Koutsaroff, Ivoyl, P., South Hamilton Ontario L8P 3B6 (CA); Zelner, Marina, Burlington Ontario L7S 2Z1 (CA); Bernacki, Thomas, A., Hamilton Ontario L8R 2J4 (CA)
(74) Representative: Jones Day

(57) **Abstract**

In accordance with the teachings described herein, low loss thin film capacitors and methods of manufacturing the same are provided. A low loss thin-film capacitor structure may include first and second electrodes and a polar dielectric between the first and second electrodes. The polar dielectric and the first and second electrodes collectively form a capacitor having an operational frequency band. The capacitor structure may also include one or more layers that affect the acoustic properties of the thin-film capacitor structure such that the capacitor absorbs RF energy at a frequency that is outside of the operational frequency band. A method of manufacturing a low loss thin-film capacitor may include the steps of fabricating a capacitor structure that includes a polar dielectric material, and modifying the acoustic properties of the capacitor structure such that the polar capacitor absorbs RF energy at a frequency that is outside of the operating frequency band of the capacitor structure.

## Description

### CROSS-REFERENCE TO RELATED APPLICATION

This application claims priority from United States Provisional Application No. 60/670,805, titled "Systems and Methods for Improving the Loss of Thin Film Capacitors," filed on April 13, 2005, which is incorporated herein by reference in its entirety.

### FIELD

The technology described in this patent document relates generally to the field of thin film devices and fabrication. More particularly, the patent document describes a low loss thin film capacitor and methods of manufacturing the same.

### BACKGROUND AND SUMMARY

Ferroelectric and paraelectric capacitors have potential for use as decoupling or voltage-tunable capacitors (varactors) in RF systems. Some benefits of ferroelectric and paraelectric capacitors are small size, integration of different values and functions of capacitance, and low cost. Applications for ferroelectric and paraelectric capacitors may include tunable filters, voltage-controlled oscillators, tunable phase shifters, tunable matching networks, low-impedance power supplies, decoupling high-frequency signals at an IC bonding pad, or others. Integrated circuits including ferroelectric and paraelectric capacitors may, for example, be used in portable electronics for low-power wireless communication (e.g., cellular phones, pagers, PDAs, etc.), directional antenna systems, high clock-rate microphones, miniature DC to DC converters, or other devices.

In accordance with the teachings described herein, low loss thin film capacitors and methods of manufacturing the same are provided. A low loss thin-film capacitor structure may include first and second electrodes and a polar dielectric between the first and second electrodes. The polar dielectric and the first and second electrodes collectively form a capacitor having an operational frequency band. The capacitor structure may also include one or more layers that affect the acoustic properties of the thin-film capacitor structure such that the capacitor absorbs RF energy at a frequency that is outside of the operational frequency band. A method of manufacturing a low loss thin-film capacitor may include the steps of fabricating a capacitor structure that includes a polar dielectric material, and modifying the acoustic properties of the capacitor structure such that the polar capacitor absorbs RF energy at a frequency that is outside of the operating frequency band of the capacitor structure.

### BRIEF DESCRIPTION OF THE DRAWINGS

Figures 1A and 1B depict a typical thin-film capacitor integrated circuit.
Figure 2 is an example thin-film capacitor having a cavity that is fabricated in the substrate layer to create a void under the capacitor.
Figure 3 is an example thin-film capacitor having a cavity that is fabricated in the substrate and insulating layers to create a void under the capacitor
Figure 4 is another example thin-film capacitor having a cavity that is fabricated in the substrate layer to create a void under the capacitor.
Figure 5 is another example thin-film capacitor having a cavity that is fabricated in the substrate and insulating layers to create a void under the capacitor.
Figure 6 is an example thin-film capacitor that includes a multi-layer acoustic reflector or absorber.
Figure 7A is an example thin-film capacitor in which the substrate layer is completely or partially removed to create a void under the capacitor.
Figure 7B is an example thin-film capacitor in which the substrate layer is completely or partially removed and that includes a cavity fabricated in a carrier substrate above the capacitor.
Figure 8 is an example thin-film capacitor in which the substrate layer is completely or partially removed that includes a multi-layer acoustic reflector or absorber fabricated in the carrier substrate above the capacitor.
Figure 9 is an example thin-film capacitor in which a cavity is fabricated between the capacitor and the substrate layer.
Figure 10 is an example thin-film capacitor that uses a thin top electrode and a thin interconnect metallization to create a void above the capacitor.
Figure 11 is an example thin-film capacitor that includes a thin single-layer top electrode.
Figure 12 is a flow diagram illustrating an example method for fabricating a thin-film capacitor integrated circuit.
Figure 13 is a flow diagram illustrating another example method for fabricating a thin-film capacitor integrated circuit.
Figure 14 is a flow diagram illustrating a third example method for fabricating a thin-film capacitor integrated circuit.
Figure 15 is a flow diagram illustrating a fourth example method for fabricating a thin-film capacitor integrated circuit.

### DETAILED DESCRIPTION

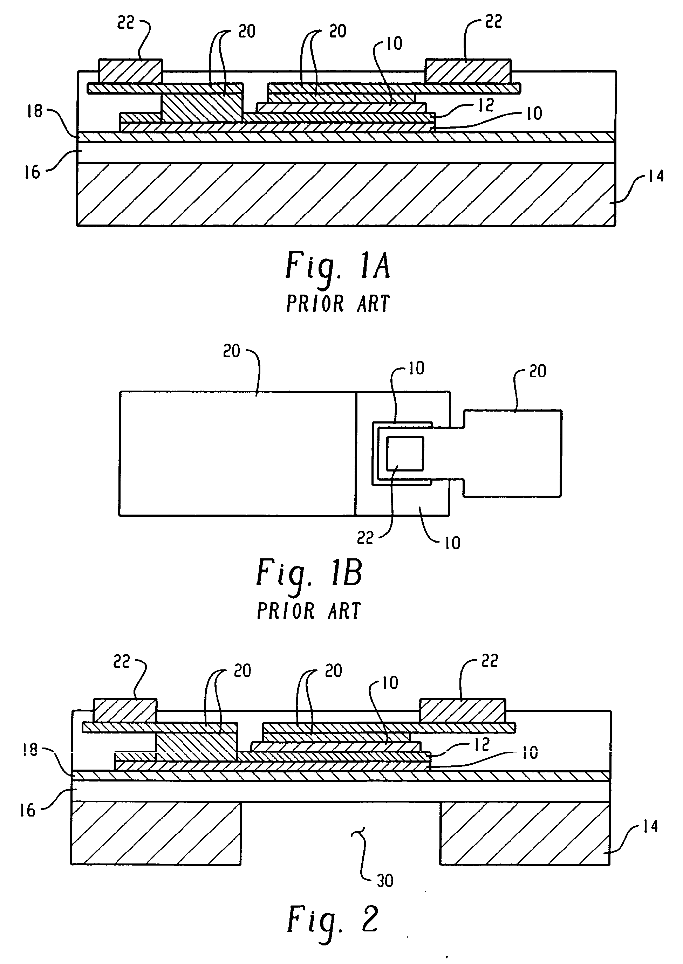

Figures 1A and 1B depict a typical thin-film capacitor integrated circuit. Figure 1A depicts a cross-sectional diagram of the capacitor structure, and Figures 1B depicts a top view showing the connections between the capacitor electrodes and an interconnect layer.

With reference to Figure 1A, the capacitor structure includes two conducting electrodes 10 that are separated by a dielectric layer 12. The conducting electrodes 10 may, for example, be fabricated using platinum or a platinum alloy. The dielectric layer 12 is fabricated using a polar dielectric material, such as barium strontium titanate (BST). The capacitor is fabricated on a substrate material 14 coated with an insulating layer 16 and an etch-resistant insulating layer 18. The substrate 14 may, for example, be Si, Al₂O₃, sapphire, or some other type of insulting, semi-insulating or semiconducting material. The insulating layer 16 may be SiO₂, and the etch-resistant insulating layer may be Si₃N₄, however other materials with similar functionality may also be used. Also illustrated in Figure 1A are conducting interconnect layers 20 that may be used to electrically connect the capacitor electrodes to other circuitry, either within in the integrated circuit (IC) package or to external circuitry via bump pads 22.

A common problem associated with thin-film capacitors made with polar dielectric materials are high losses at specific frequencies, particularly in the 0.1 to 10 GHz range. These frequency-specific losses are fundamental to the properties of ferroelectric and paraelectric materials, and are directly related to the change of the dielectric constant with applied electric field.

Figures 2-11 illustrate example low loss thin film capacitor structures that are fabricated from polar dielectric materials, while avoiding high, frequency-specific losses, particularly in the 0.1 to 10 GHz frequency range under an applied electric field in the range of about 0.1 megavolts/cm (MV/cm) to about 10 (MV/cm). This result is achieved by modifying the capacitor structure to change the acoustic reflections at the electrodes or other layers of the capacitor structure, such that the capacitor structure dielectric absorbs RF energy at a different frequency than the frequency required for the particular application. The cause of the RF energy absorption is electrostrictive resonance. When a ferroelectric material is voltage biased, for example to change the dielectric constant, the crystal lattice of the grains in the film are distorted. A varying electric field (from the RF signal) modulates this distortion, generating acoustic energy that is reinforced by the surrounding films in the structure. The example capacitor structures described herein are modified to increase the frequency at which the resonance is reinforced, resulting in capacitors having low RF energy absorption and high Q-values throughout the operational frequency band (e.g., throughout the 0.1 to 10 GHz frequency band under voltage biases between 0.1 MV/cm to 10 MV/cm.) These capacitors can be either single devices or integrated into a circuit on the substrate with other components such as other capacitors, resistors and/or inductors.

Figure 2 is an example thin-film capacitor structure having a cavity 30 that is fabricated in the substrate layer 14 to create a void 30 under the capacitor 10, 12. The void 30 under the capacitor 10, 12 serves as an acoustic reflector, which modifies the electrostrictive resonance of the capacitor structure. In this manner, the electrostrictive resonance frequency of the capacitor structure may be modified to improve the loss in the operational frequency band (e.g., from 0.1 to 10 GHz.) The cavity 30 may be created by selectively removing the substrate 14, for example by laser drilling, ultrasonic milling (e.g., for ceramic substrates), deep RIE, wet anisotropic etching (e.g., on <110> oriented silicon), or other fabrication techniques.

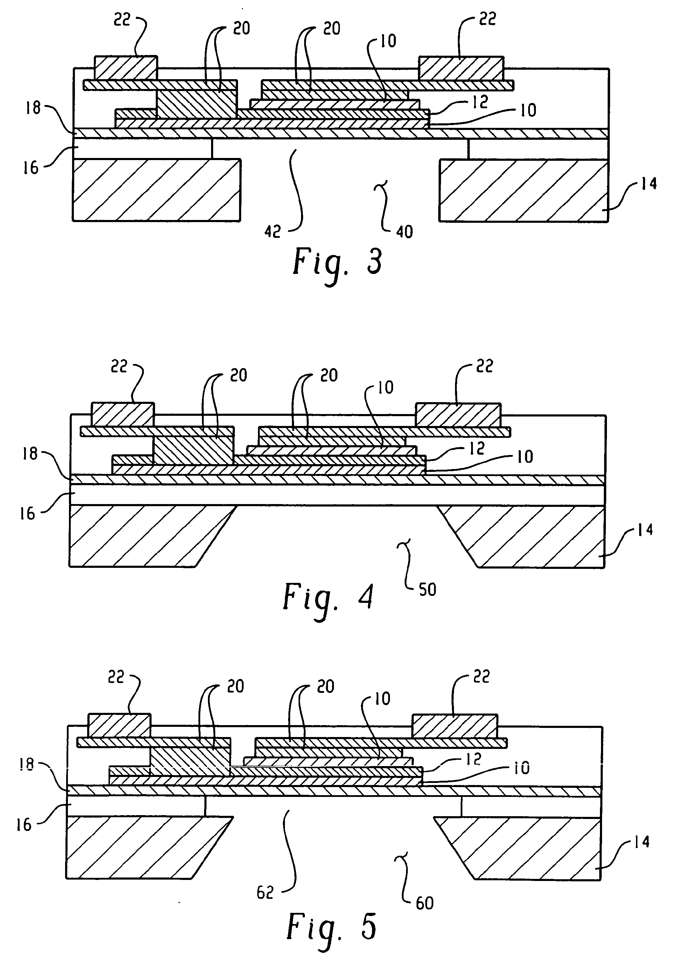

Figure 3 is an example thin-film capacitor structure having a cavity 40 that is fabricated both in the substrate 14 and insulating layers 16 to create a void under the capacitor. In this example the insulating layer 16 is etched after the substrate layer 14. The insulating layer may, for example, be etched using a wet etch based on hydrofluoric acid, a dry RIE etch, or some other means. Removing the insulating layer 16 creates a thinner acoustic layer between the capacitor 10, 12 and the void 40, further increasing the electrostrictive resonance frequency of the capacitor structure compared to the example of Figure 1.

Figure 4 is another example thin-film capacitor structure having a cavity 50 that is fabricated in the substrate layer 14 to create a void 50 under the capacitor 10, 12. Figure 5 is another example thin-film capacitor structure having a cavity 60, 62 that is fabricated in the substrate 14 and insulating layers 16 to create a void under the capacitor 10, 12. The thin-film capacitors shown in Figures 4 and 5 are similar to the examples of Figures 2 and 3, respectively, except that the substrate layer 14 is etched using an anisotropic backside wet etch. Anisotropic etching may, for example, be used in the case of a <100> silicon substrate.

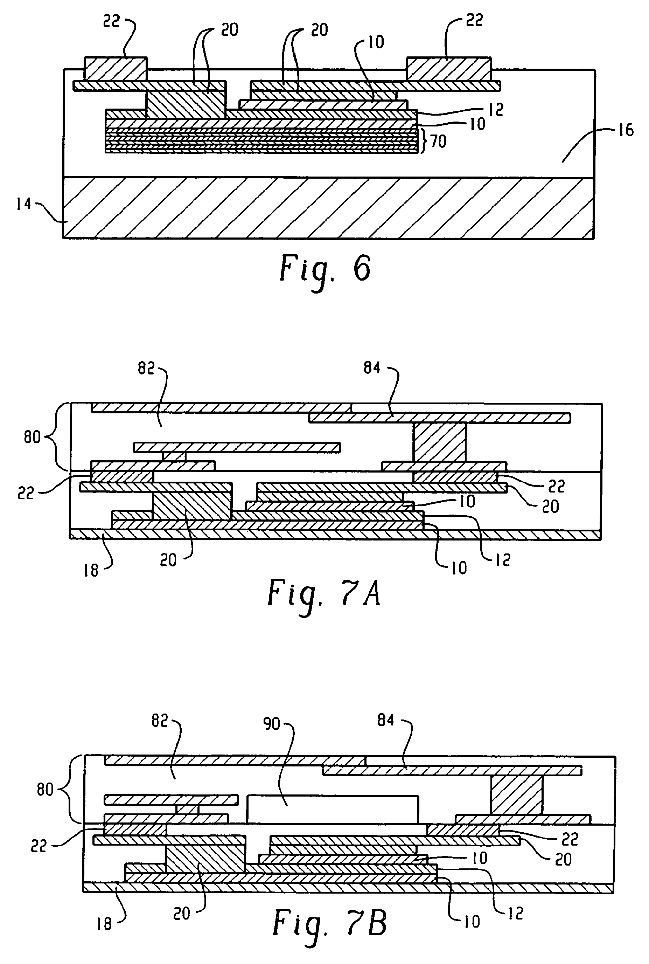

Figure 6 is an example thin-film capacitor structure that includes a multi-layer acoustic reflector or absorber 70. In this example the multi-layer acoustic reflector or absorber 70 is fabricated between the capacitor 10, 12 and the substrate layer 14. The multi-layer reflector or absorber 70 includes two or more layers of alternating materials of different acoustic properties, which can be selected to either reflect or absorb the acoustic waves depending on the desired capacitor properties. The materials used to fabricate the layers of the acoustic reflector or absorber 70 and the thickness of the layers 70 may be selected to either reflect or absorb the acoustic wave at desired frequencies in order to modify the electrostrictive resonance of the capacitor structure in the operating frequency band (e.g., from 0.1 to 10 GHz.)

Figure 7A is an example thin-film capacitor structure in which the substrate layer is completely or partially removed to create a void under the capacitor 10, 12. In this example, the capacitor structure is bonded to a carrier substrate 80, for example using flip-chip bonding methods. The carrier substrate 80 includes a substrate material 82, and conducting layers 84 which provide connections to bonding pads 22 on the thin-film capacitor IC. In other examples, the carrier substrate may also include additional layers, including for example active and/or passive thin-film components. After the thin-film capacitor structure is bonded to the carrier substrate 80, the substrate layer of the thin-film capacitor may be removed, leaving only the thin insulating layer 18 between the capacitor 10, 12 and an air void. In this manner, the air void under the capacitor 10, 12 serves as an acoustic reflector, which modify the electrostrictive resonance of the capacitor structure. Moreover, the carrier substrate 80 provides the necessary physical support to maintain the structural integrity of the thin-film capacitor structure after the substrate has been completely or partially removed. The thin-film capacitor substrate may, for example, be removed using either mechanical or chemical methods.

Figure 7B is another example thin-film capacitor structure in which the substrate layer is completely or partially removed that includes a cavity fabricated in a carrier substrate 80 above the capacitor 10, 12. This example is similar to the capacitor structure of Figure 7A, with the addition of the cavity 90 in the carrier substrate 80. The cavity 90 above the capacitor 10, 12 forms an acoustic reflector, which further modifies the electrostrictive resonance of the capacitor structure.

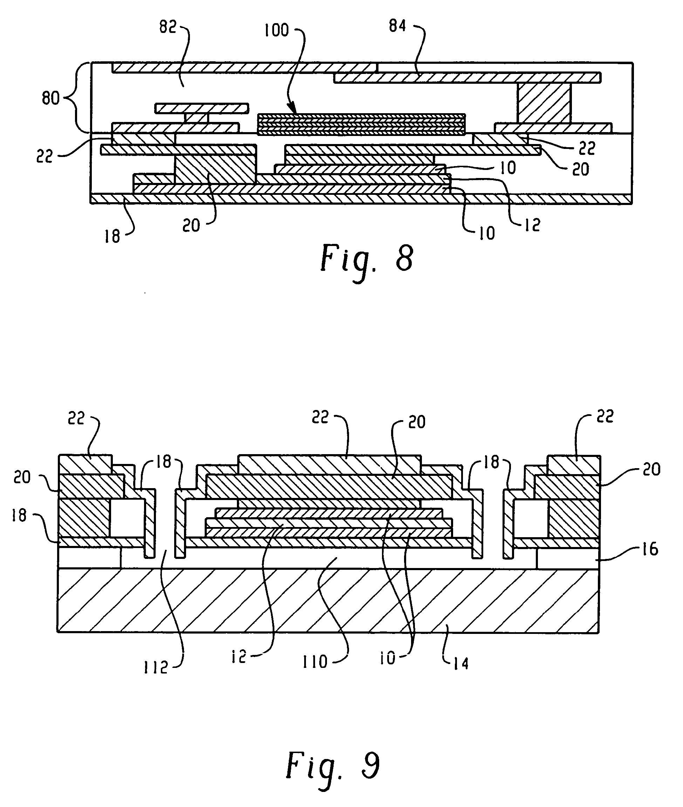

Figure 8 is another example thin-film capacitor in which the substrate layer is completely or partially removed that includes a multi-layer acoustic reflector or absorber 100 fabricated in the carrier substrate 80 above the capacitor 10, 12. The multi-layer reflector or absorber 100 includes two or more layers of alternating materials of different acoustic properties, which can be selected to either reflect or absorb the acoustic waves depending on the desired capacitor properties. The air void under the capacitor 10, 12, which is created by completely or partially removing the substrate, serves as an acoustic reflector and combines with the multi-layer reflector or absorber 100 to modify the electrostrictive resonance of the capacitor 10, 12. The materials used to fabricate the layers of the acoustic reflector or absorber 100 and the thickness of the layers 100 may be selected to either reflect or absorb the acoustic wave at desired frequencies in order to modify the electrostrictive resonance of the capacitor structure in the operating frequency band (e.g., from 0.1 to 10 GHz.)

Figure 9 is an example thin-film capacitor structure in which a cavity 110 is fabricated between the capacitor 10, 12 and the substrate layer 14. The cavity 110 serves as an acoustic reflector, which raises the electrostrictive resonance frequency of the capacitor structure and may be used to modify the electrostrictive resonance of the capacitor structure in the operational frequency band (e.g., from 0.1 to 10 GHz.) The cavity 110 may be fabricated by etching a portion of the insulating layer 16 through front-side access holes 112. The access holes 112 may, for example, be etched through the interlayer dielectric, lower electrode material and the underlying etch-resistant insulating layer to give access to the etchable insulating layer. The access holes 112 may then be lined with an etch-resistant insulating layer 18 to prevent damage to the capacitor 10, 12 and conducting layers 20. The cavity 110 may be formed by wet etching the insulating layer 16 through the access holes 112.

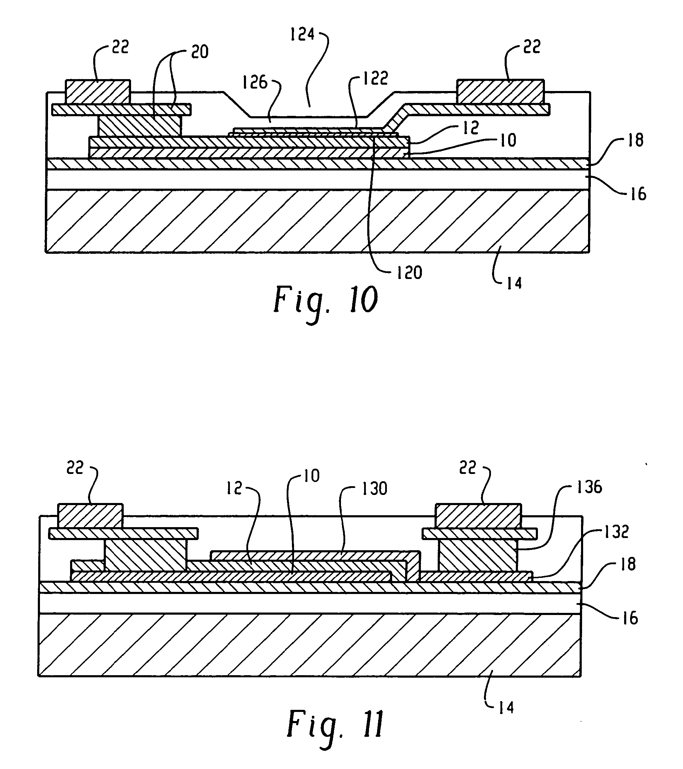

Figure 10 is an example thin-film capacitor structure that uses a thin top electrode 120 and a thin interconnect metallization 122 to create a void 124 above the capacitor 10, 12, 120. The void 124 above the capacitor serves as an acoustic reflector, which modifies the electrostrictive resonance of the capacitor structure in the operational frequency band (e.g., from 0.1 to 10 GHz.) The void 124 is created by fabricating the top electrode 120 of the capacitor and the attached interconnect metallization 122 from thin conductive layers and by minimizing the amount of insulating material 126 between the top capacitor electrode 120 and the air medium 124.

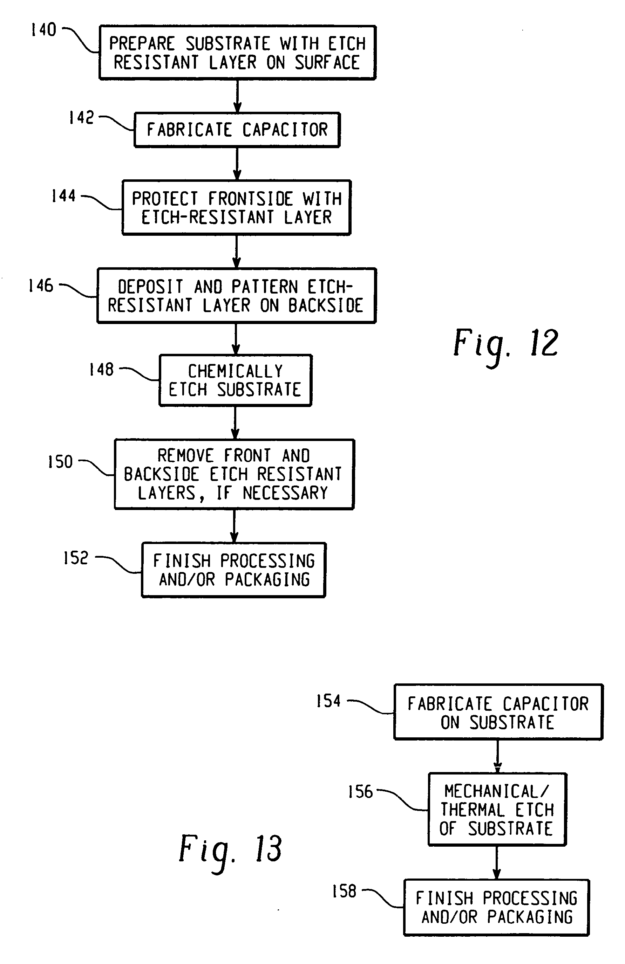

Figure 11 is an example thin-film capacitor structure that includes a thin single-layer top electrode 130. In this example, the top electrode 130 of the capacitor includes an extended portion 132 that extends horizontally away from the capacitor in order to provide an electrical connection between the top electrode 130 and the interconnect metallization 136 The extended portion 132 of the top electrode 130 enables the interconnect metallization 136 to be horizontally offset from the top electrode 130, thus minimizing the thickness of material between the top electrode 130 and the air medium above the capacitor. In this manner, the air medium above the capacitor 10, 12, 120 acts as an acoustic reflector, which modifies the electrostrictive resonance of the capacitor structure.

Figure 12 is a flow diagram illustrating an example method for fabricating a thin-film capacitor integrated circuit. At step 140, a substrate layer is prepared with an etch-resistant layer on the surface to protect the capacitor and to act as an etch-stop for backside etching. The capacitor is fabricated on the substrate using conventional fabrication techniques at step 142. At step 144, the front side of the capacitor is protected with an etch-resistant layer, and another etch-resistant layer is deposited and patterned on the backside at step 146. At step 148, the substrate layer is completely or partially removed using wet or dry chemical etching or a combination of both. Either a timed etch or the etch-resistant layer may be used to terminate the chemical etch. Once the substrate is etched, the front and backside etch-resistant layers may be removed at step 150, and any additional fabrication and/or packaging processing is performed at step 152.

Figure 13 is a flow diagram illustrating another example method for fabricating a thin-film capacitor integrated circuit. At step 154, a capacitor structure is fabricated on a substrate material using conventional fabrication techniques. Substrate material is then removed to a pre-determined depth at step 156, stopping short of removing capacitor material. The substrate material may, for example, be removed using a laser, abrasive chemicals, ultrasonic milling and/or other mechanical or thermal means. Any additional fabrication and/or packaging processes may then be performed at step 158.

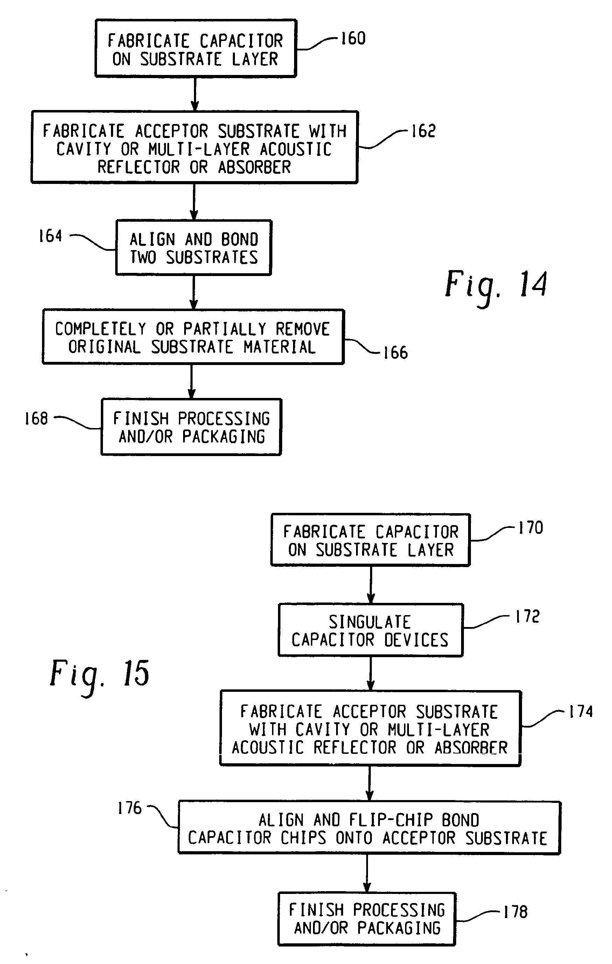

Figure 14 is a flow diagram illustrating a third example method for fabricating a thin-film capacitor integrated circuit. At step 160, the capacitor is fabricated on a substrate material using conventional fabrication techniques. An acceptor substrate is then fabricated at step 162 that includes one or more cavities or multi-layer acoustic reflector or absorber structures (e.g., the carrier substrate 80 in Figures 7A, 7B and 8). At step 164, the acceptor substrate and the capacitor are aligned and bonded, for example using flip-chip bonding techniques. The original substrate is then completely or partially removed from the backside of the capacitor at step 166. The substrate may, for example, be removed using mechanical or chemical methods. Any additional fabrication and/or packaging processing may then be performed at step 168. The additional fabrication steps may include etching contact holes in the insulating layer on the backside and adding metal to reduce the series resistance of the capacitor.

Figure 15 is a flow diagram illustrating a fourth example method for fabricating a thin-film capacitor integrated circuit. At step 170 the capacitor is fabricated on a substrate material using conventional fabrication techniques. Capacitor devices are then singulated at step 172. An acceptor substrate is fabricated at step 164 that includes one or more cavities or multi-layer acoustic reflector or absorber structures (e.g., the carrier substrate 80 in Figures 7A, 7B and 8). At step 176, the acceptor substrate and the singulated capacitor are aligned and bonded, for example using flip-chip bonding techniques. Any additional fabrication and/or packaging processing may then be performed at step 178. The additional fabrication steps may include etching contact holes in the insulating layer on the backside and adding metal to reduce the series resistance of the capacitor.

This written description uses examples to disclose the invention, including the best mode, and also to enable a person skilled in the art to make and use the invention. The patentable scope of the invention may include other examples that occur to those skilled in the art

## Claims

1. A low loss thin-film capacitor structure, comprising:
first and second electrodes;
a polar dielectric between the first and second electrodes, the polar dielectric and the first and
second electrodes collectively forming a capacitor having an operational frequency band; and
one or more layers that affect the acoustic properties of the thin-film capacitor structure such that the capacitor absorbs radio frequency (RF) energy at a frequency that is outside of the operational frequency band.

2. The thin-film capacitor structure of claim 1, wherein the one or more layers include a substrate layer that defines a cavity, and wherein the cavity affects the acoustic properties of the thin-film capacitor structure such that the capacitor absorbs energy at a frequency that is outside of the operational frequency band.

3. The thin-film capacitor structure of claim 1 or 2, wherein the one or more layers include an insulating layer that defines a cavity, and wherein the cavity affects the acoustic properties of the thin-film capacitor structure such that the polar dielectric absorbs RF energy at a frequency that is outside of the operational frequency band.

4. The thin-film capacitor structure of any of claims 1 to 3, wherein the one or more layers include a substrate layer and an insulating layer that define a cavity, and wherein the cavity affects the acoustic properties of the thin-film capacitor structure such that the capacitor absorbs energy at a frequency that is outside of the operational frequency band.

5. The thin-film capacitor structure of any of claims 1 to 4, wherein the one or more layers include an acoustic reflector that affects the acoustic properties of the thin-film capacitor structure such that the polar dielectric absorbs RF energy at a frequency that is outside of the operational frequency band.

6. The thin-film capacitor structure of any of claims 1 to 5, wherein the one or more layers include an acoustic absorber that affects the acoustic properties of the thin-film capacitor structure such that the capacitor absorbs RF energy at a frequency that is outside of the operational frequency band.

7. The thin-film capacitor structure of claim 5, wherein the acoustic reflector includes two or more layers with each layer of the acoustic reflector having a different acoustic impedance than adjacent layers of the acoustic reflector.

8. The thin-film capacitor structure of claim 5, wherein the acoustic absorber includes two or more layers with each layer of the acoustic absorber having a different acoustic impedance than adjacent layers of the acoustic absorber.

9. The thin-film capacitor structure of any of claims 1 to 8, wherein the one or more layers separate one of the first or second electrodes from an air void and the acoustic properties of the thin-film capacitor structure are affected by a thickness of the one or more layers.

10. A method of manufacturing a low loss thin-film capacitor, comprising:
fabricating a capacitor structure that includes a polar dielectric material, the capacitor structure having an operational frequency band; and
modifying the acoustic properties of the capacitor structure such that the capacitor material absorbs RF energy at a frequency that is outside of the operating frequency band.

11. The method of claim 10, wherein the acoustic properties of the capacitor structure are modified by forming a cavity in one or more layers of the capacitor structure.

12. The method of claim 11, wherein the void is formed in an insulating layer.

13. The method of claim 11, wherein the void is formed in a substrate layer.

14. The method of claim 11, wherein the void is formed in an insulating layer and a substrate layer.

15. The method of any of claims 10 to 14, wherein the acoustic properties of the capacitor structure are modified by fabricating an acoustic reflector structure that includes two or more layers with each layer having a different acoustic impedance than adjacent layers.

16. The method of any of claims 10 to 15, wherein the acoustic properties of the capacitor structure are modified by fabricating an acoustic absorber structure that includes two or more layers with each layer having a different acoustic impedance than adjacent layers.

17. The method of any of claims 10 to 16, wherein the acoustic properties of the capacitor structure are modified by fabricating an insulating layer between the capacitor structure and an air void, wherein the acoustic properties of the capacitor structure are affected by a thickness of the insulating layer.

18. The method of any of claims 10 to 17, wherein the capacitor structure is fabricated on a substrate material and wherein the substrate material is subsequently removed to modify the acoustic properties of the capacitor structure.

19. A low loss thin-film capacitor structure, comprising:
first and second electrodes;
a polar dielectric between the first and second electrodes, the polar dielectric and the first and
second electrodes collectively forming a capacitor having an operational frequency band; and
means for affecting the acoustic properties of the thin-film capacitor structure such that the capacitor absorbs RF energy at a frequency that is outside of the operational frequency band.
